# EUROPEAN PATENT SPECIFICATION

(11) **EP 2 464 043 B1**
(45) Date of publication and mention of the grant of the patent: **13.03.2019**
(21) Application number: 09848038.7
(22) Date of filing: 03.08.2009
(51) Int. Cl.: H04J 3/06, H04L 12/44, H04L 7/04, H04B 10/50

(54) **OPTICAL LINE TERMINATION, PON SYSTEM, AND DATA RECEPTION PROCESSING METHOD**
OPTISCHER LEITUNGSABSCHLUSS, PON-SYSTEM UND VERFAHREN FÜR DATENEMPFANGSVERARBEITUNG
TERMINAISON DE LIGNE OPTIQUE, SYSTÈME PON ET PROCÉDÉ DE TRAITEMENT DE RÉCEPTION DE DONNÉES

(43) Date of publication of application: 13.06.2012
(73) Proprietor: Mitsubishi Electric Corporation, Tokyo 100-8310 (JP)
(72) Inventor: NAKURA, Kenichi, Tokyo 100-8310 (JP); SUZUKI, Naoki, Tokyo 100-8310 (JP); SUGIMURA, Koshi, Tokyo 100-8310 (JP)
(74) Representative: Pfenning, Meinig & Partner mbB
(86) International application number: PCT/JP2009/063761
(87) International publication number: WO 2011/016105

(56) References cited:
- EP-A1- 2 007 040
- EP-A2- 1 333 612
- JP-A- 2007 067 599
- JP-A- 2008 177 773
- US-B1- 7 352 835

## Description

### Field

The present invention relates to an optical line termination and a data reception processing method in a PON (Passive Optical Network) system.

### Background

In a PON system, a plurality of termination devices (ONU: Optical Network Unit, ONT: Optical Network Termination) are connected to an OLT (Optical Line Termination) placed on a station side with an optical coupler and an optical fiber in a 1-to-multiple connection method. Each ONU transmits data in a time division manner, by which an access control is performed to prevent collision of data in the optical coupler. This control causes the OLT to receive data intermittently. The OLT regenerates data by extracting clock from the intermittently received data. Furthermore, a SERDES (Serializer/Deserializer) in the OLT parallelize data by extracting clock from the regenerated data.

A circuit that regenerates data (hereinafter, "data regenerating circuit") by extracting clock from the received data outputs data with an indefinite rate that is different from a transmission line rate (a rate of reception data) in an interval where there is no reception data. When a PLL (Phase Locked Loop) or the like is used in the SERDES, if the circuit receives data with such an indefinite rate, the SERDES becomes unable to extract a proper clock. Therefore, once the data regenerating circuit is to output reception data again, it takes some time for the SERDES to become able to receive data in a proper manner by extracting the clock in properly. Therefore, when the ONU performs intermittent data transmission in the PON system, a standby period is set until the OLT becomes able to receive data.

As a technique for the OLT to shorten a synchronizing time, for example, Patent Literature 1 mentioned below discloses a technique of preventing a PLL from being out of synchronization by switching a reference of the PLL from input data to a reference clock.

### Citation List

### Patent Literature

Patent Literature 1: Japanese Patent Application Laid-open No. 2007-159145

US 7,352,835 B1 describes a clock data recovery circuit with dynamic support for changing data rates and a dynamically adjustable PPM detector.

EP 2 007 040 A1 describes a PON burst mode receiver with fast decision threshold setting.

EP 1 333 612 A2 describes an idle-pattern output control circuit in a GBit Ethernet-passive optical network.

### Summary

### Technical Problem

However, in the conventional technique described above, although a standby period is set when the ONU performs intermittent data transmission, it is not possible to perform any data transmission in that period. Therefore, there has been a problem in that a bandwidth is wasted as the standby period becomes longer.

The present invention has been made in view of the above problems, and an object of the present invention is to provide an optical line termination and a data reception processing method by use of which it is possible to shorten a standby period until data can be received.

### Solution to Problem

In order to solve the above problems and achieve an object, according to the present invention, included are: a deserializer that parallelizes burst data received from a termination device; a dummy-data generating unit that generates dummy data; and a data selecting unit that detects whether there is the burst data, selects either the dummy data or the burst data based on the detection result, and inputs selected data to the deserializer.

### Advantageous Effects of Invention

With the optical line termination, the PON system, or the data reception processing method according to the present invention, it is possible to shorten a standby period until data can be received.

### Brief Description of Drawings

FIG. 1 is a functional configuration example of an OLT according to a first embodiment.
FIG. 2 is an overall configuration example of the OLT according to the first embodiment.
FIG. 3 is a configuration example of a deserializer.
FIG. 4 is an example of a transmission timing control for an ONU executed by the OLT.
FIG. 5 is an example of allocation information stored in an uplink-slot managing unit.
FIG. 6 is an example of an operation timing according to the first embodiment.
FIG. 7 is a flowchart of an example of an operation procedure of a data selecting unit according to the first embodiment.
FIG. 8 is a functional configuration example of an OLT according to a second embodiment.
FIG. 9 is an example of an operation according to the second embodiment.
FIG. 10 is an example of a format of data transmitted from an ONU to the OLT.
FIG. 11 is a functional configuration example of an OLT according to a third embodiment.
FIG. 12 is a flowchart of an example of an operation procedure of a data selecting unit when performing recognition of a head of burst.
FIG. 13 is a functional configuration example of an OLT according to a fourth embodiment.

### Description of Embodiments

Exemplary embodiments of an optical line termination and a data reception processing method according to the present invention will be explained below in detail with reference to the accompanying drawings. The present invention is not limited to the embodiments.

### First embodiment

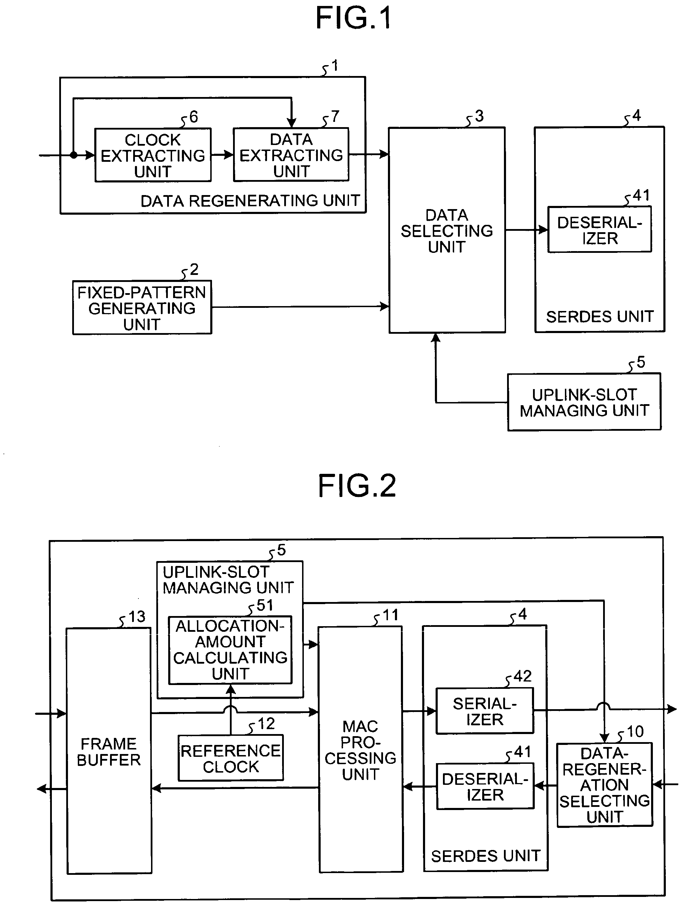

FIG. 1 is a functional configuration example of an optical line termination (OLT) according to a first embodiment of the present invention. The OLT according to the present embodiment is connected to a plurality of ONUs with an optical coupler and an optical fiber. FIG. 1 depicts constituent elements for implementing an operation of a data processing method according to the present invention. As shown in FIG. 1, the OLT according to the present embodiment includes a data regenerating unit 1 that extracts clock from data (burst data) intermittently received from the ONU and regenerates the data, a fixed-pattern generating unit (a data generator or a pattern signal generator) 2 that generates fixed data, a data selecting unit (a data selector) 3 that determines output data based on whether there is burst data to be received (a reception period), a SERDES unit 4, and an uplink-slot managing unit 5. The uplink-slot managing unit 5 has a function for controlling a transmission timing of the ONU, performs an access control of the PON, determines whether there is the burst data based on the transmission timing of the ONU, and outputs a burst head instruction signal and a burst end instruction signal.

The data regenerating unit 1 is configured by a clock extracting unit 6 that extracts clock from the burst data and a data extracting unit 7 that regenerates data based on the extracted clock and the burst data. Although a configuration example is shown here in which a PLL is employed in the data regenerating unit 1, the configuration for regenerating the burst data is not limited to a particular method, but can be any other configuration such as a configuration without employing any PLL.

FIG. 2 is an overall configuration example of the OLT according to the present embodiment. As shown in FIG. 2, the optical line termination according to the present embodiment is configured by the SERDES unit 4, a data-regeneration selecting unit 10, a MAC processing unit 11 that performs frame forming of transmission data, a conversion process of converting reception data into a predetermined data format and the like, the uplink-slot managing unit 5, a reference clock 12 that generates clock that works as a reference of a process of the uplink-slot managing unit 5, and a frame buffer 13 that is a buffer for storing the transmission data and the reception data.

The data-regeneration selecting unit 10 is configured by the data selecting unit 3, the data regenerating unit 1, and the fixed-pattern generating unit 2 shown in FIG. 1. The SERDES unit 4 includes a deserializer 41 that parallelizes a signal input from the data selecting unit 3 of the data-regeneration selecting unit 10 and a serializer 42 that serializes transmission data output from the MAC processing unit 11 as a parallel signal. The uplink-slot managing unit 5 includes an allocation-amount calculating unit 51.

The data to be transmitted to the ONU (downlink data) is input to the MAC processing unit 11 via the frame buffer 13. The MAC processing unit 11 makes the transmission data into a PON frame and outputs it to the serializer 42 of the SERDES unit 4. The serializer 42 serializes the transmission data input as a parallel signal and transmits a serialized signal.

The reception data from the ONU (uplink data) is subjected to a clock extraction process and a data regeneration process by the data-regeneration selecting unit 10 and then input to the deserializer 41 of the SERDES unit 4. The deserializer 41 parallelizes the reception data input as the serial signal and outputs it to the MAC processing unit 11. The MAC processing unit 11 performs a process such as a conversion of the parallelized data into a predetermined data format and outputs the result of the process to a user device and the like via the frame buffer 13.

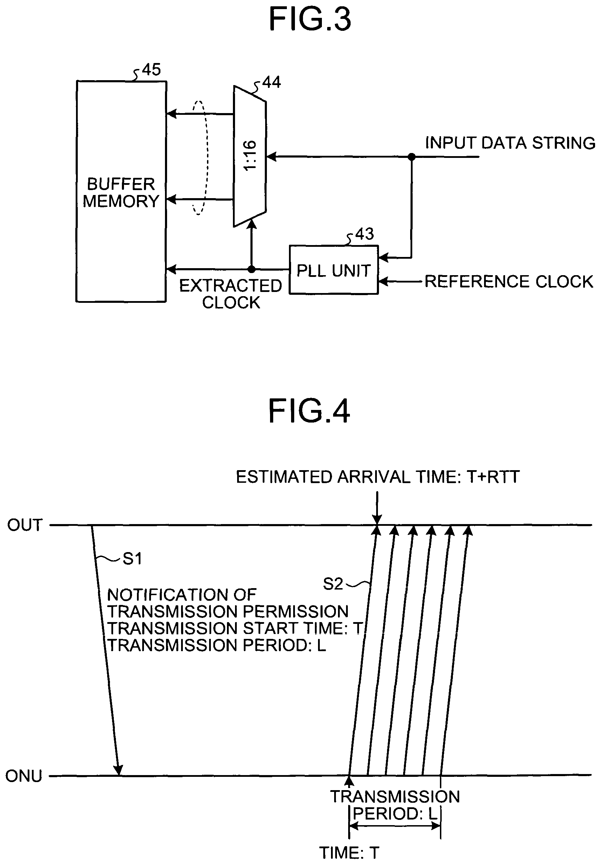

FIG. 3 is a configuration example of the deserializer 41 of the SERDES unit 4. FIG. 3 is an example of parallelizing the serial signal into 16 bits. As shown in FIG. 3, the deserializer 41 is configured by a PLL unit 43 that is a PLL circuit (a phase synchronizing circuit) that extracts clock from an input data string (reception data) based on a reference clock, a 1-to-16 parallelizing unit (1:16) 44 that converts the input serial signal into a 16-bit parallel signal based on the clock extracted by the PLL unit 43, and a buffer memory 45 for storing the converted parallel signal and the clock extracted by the PLL unit 43. Although an example of parallelizing data into 16-bit width is shown here, if the parallelization is performed with a width other than 16 bits, a parallelizing unit supporting a corresponding bit width can be used instead of the 1-to-16 parallelizing unit.

When the deserializer 41 of the SERDES unit 4 extracts the clock by using the PLL circuit (the PLL unit 43) as shown in FIG. 3, if an input data string with an indefinite rate is received, it causes a state where a proper clock cannot be extracted. In the PON system, the OLT receives data intermittently, and the rate becomes indefinite in an interval where there is no reception data, leading to a state where a proper clock cannot be extracted. Once it becomes in a state where the clock cannot be extracted, it takes some time for the deserializer 41 to be able to extract the clock properly even if data is received thereafter.

To deal with this problem, in a conventional case, when data is received after the state where a proper clock cannot be extracted in the interval where there is no reception data, there has been proposed a method in which the SERDES switches the reference of the PLL in order to shorten the time until the proper clock can be extracted (a synchronizing time). However, in this method, it is necessary to add an extra function to the SERDES.

On the other hand, in the present embodiment, as indicated below, it is configured that clock can be extracted continuously even in the interval where there is no reception data by causing a fixed pattern, which is a data string from which the clock can be extracted in the interval where there is no reception data, to be input to the deserializer 41 based on a transmission start time and a transmission period of each ONU stored in the uplink-slot managing unit 5. Therefore, without adding any extra function to the SERDES, it is possible to start a proper reception process rapidly when the data reception is resumed.

An operation of the present embodiment is explained next. First, an operation example of the uplink-slot managing unit 5 is explained. In the PON system, a data transmission timing of the ONU is controlled by the OLT, and in the present embodiment, the uplink-slot managing unit 5 executes this control.

FIG. 4 is an example of a transmission timing control for the ONU executed by the OLT. The allocation-amount calculating unit 51 of the uplink-slot managing unit 5 of the OLT determines a transmission start time T and a transmission period L for each ONU based on the reference clock generated by the reference clock 12 and notifies the determined transmission start time T and transmission period L to the ONU (Step S1). The ONU obtains a transmission permission by the notification of the transmission start time and the transmission period. The ONU can start a transmission of data from the transmission time T specified by the notification from the OLT (Step S2) and transmit the data from the data transmission start until the end of the transmission period (T+L). Therefore, in the OLT, it is possible to estimate a time at which the data arrive from the ONU in advance.

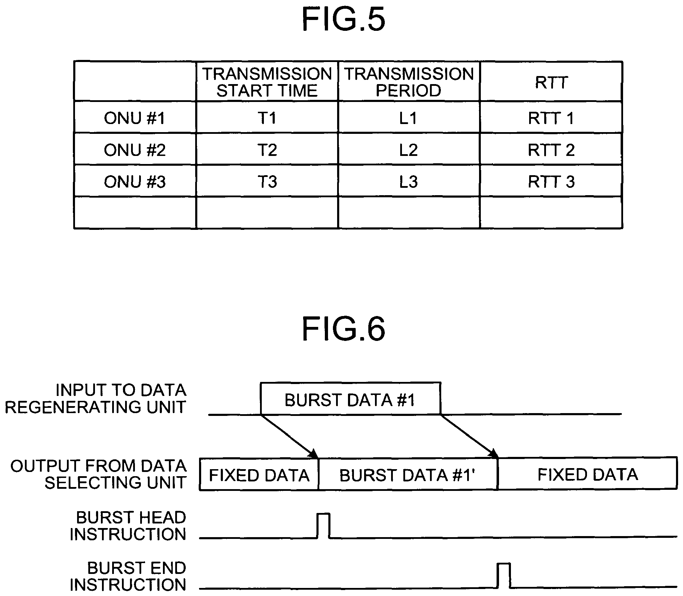

The uplink-slot managing unit 5 stores the transmission start time and the transmission period of each ONU determined by the allocation-amount calculating unit 51 as allocation information and performs checking whether the data arrived at a right time from each ONU based on the allocation information. FIG. 5 is an example of the allocation information stored in the uplink-slot managing unit 5. As shown in FIG. 5, for example, when the transmission timing control is performed for ONU #1 to ONU #3, the transmission start time, the transmission period, and RTT (Round Trip Time) are included for each ONU. The RTT is a round trip delay time between the OLT and the ONU, which is measured in advance by the OLT. Alternatively, the RTT can be measured on a regular basis so that its value is updated based on the measurement result.

It is assumed that the reference time of each ONU is delayed compared to the reference time of the OLT by a delay time from the OLT to each ONU. Therefore, when the ONU transmitted data at a time T, the data is transmitted at a time T+A (where A is the delay time from the OLT to each ONU) in the reference time of the OLT. The OLT receives the data transmitted from the ONU at a time (T+a+B=T+RTT) when a delay time B is further elapsed from T+A.

As described above, in the OLT, it is possible to obtain the time to start receiving data and the time to end receiving data transmitted from each ONU based on the transmission start time, the transmission period, and the RTT. In the present embodiment, the uplink-slot managing unit 5 outputs the burst head instruction signal at the time to start receiving the data transmitted from each ONU (a burst start position) and the burst end instruction signal at the time to end receiving the data (a burst end position) to the data selecting unit 3.

FIG. 6 is an example of an operation timing according to the present embodiment. In FIG. 6, the horizontal axis represents time, the first line represents data input to the data regenerating unit 1, the second line represents data output from the data selecting unit 3. The third line represents the burst head instruction signal output from the uplink-slot managing unit 5, and the fourth line represents the burst end instruction signal output from the uplink-slot managing unit 5.

FIG. 6 is an example in which the burst data #1 is transmitted from the ONU, and there is an interval before and after the burst data #1 in which there is no transmission. In this example, the uplink-slot managing unit 5 outputs the burst head instruction signal, raising its level from Low to High, at a burst head position and the burst end instruction signal, raising its level from Low to High, at a burst end position. The data selecting unit 3 determines that the burst end instruction is received when the burst end instruction signal becomes High and selects fixed data output from the fixed-pattern generating unit 2 as data to be output to the SERDES unit 4. That is, when there is no transmission data from the ONU, the data selecting unit 3 selects the data output from the fixed-pattern generating unit 2 and outputs it to the SERDES unit 4.

Dummy data is data with a sufficiently long hamming distance between a burst head identifier and a burst end identifier. The dummy data is transmitted according to clock and makes a transition to 0 or 1 according to a phase of the clock. Therefore, the dummy data can supply required phase information to a phase synchronizing circuit.

The fixed pattern generated by the fixed-pattern generating unit 2 is configured to be generated as data having a sufficient data change for the SERDES unit 4 to extract the clock. Therefore, the SERDES unit 4 becomes in a stable state where it can extract a proper clock even when there is no transmission data from the ONU. Although the fixed pattern can be any type of data, for example, it is possible to use a PRBS7 generating polynomial or a pseudo-random pattern based on PRBS31. Furthermore, although it is configured to generate fixed data as the fixed pattern in the present embodiment, it is not limited to the fixed data, but any data can be used as long as the data is dummy data having comparable rates of 0's and 1's in a predetermined period. The data may be different for each time. That is, the fixed-pattern generating unit 2 is a sort of dummy-data generating unit. The dummy-data generating unit is a unit that generates dummy data (including fixed data) according to a predetermined operation rule.

Furthermore, when the burst head instruction signal becomes High, the data selecting unit 3 determines that the burst head instruction is received, and selects data output from the data regenerating unit 1 as data to be output to the SERDES unit 4 (the burst data #1' in FIG. 6).

In this manner, because the SERDES unit 4 is in a stable state even when there is no transmission data from the ONU, the SERDES unit 4 can receive data in a stable state at a later time when the transmission data is received from the ONU, which can parallelize proper data rapidly. If the burst end instruction signal is further input from the uplink-slot managing unit 5 (that is, the burst end instruction signal becomes High), the data selecting unit 3 selects the fixed data from the fixed-pattern generating unit 2, outputs the selected data to the SERDES unit 4, and becomes in a standby state waiting for the burst head instruction.

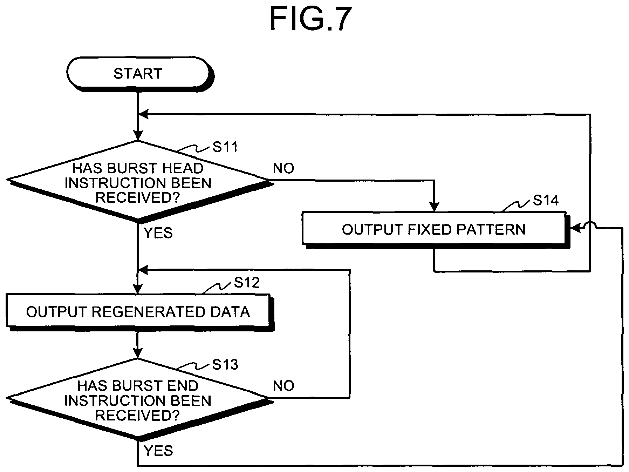

FIG. 7 is a flowchart of an example of an operation procedure of the data selecting unit 3 according to the present embodiment. First, the data selecting unit 3 determines whether the burst head instruction is received or not (Step S11). When it is determined that the burst head instruction is received (YES at Step S11), the data selecting unit 3 outputs data output from the data regenerating unit 1 (hereinafter, "regenerated data") to the SERDES unit 4 (Step S12).

Thereafter, the data selecting unit 3 determines whether the burst end instruction is received or not (Step S13). When it is determined that the burst end instruction is received (YES at Step S13), the data selecting unit 3 selects data output from the fixed-pattern generating unit 2, outputs the selected data to the SERDES unit 4 (Step S14), and the process returns to Step S11. On the other hand, when it is determined that the burst head instruction is not received at Step S11 (NO at Step S11), the process proceeds to Step S14. When it is determined that the burst end instruction is not received at Step S13 (NO at Step S13), the process returns to Step S12.

As described above, in the present embodiment, it is configured that the burst head instruction and the burst end instruction are output based on information stored in the uplink-slot managing unit 5 that performs an access control of the PON, and the data selecting unit 3 selects either the fixed pattern or the burst data as data to be output to the SERDES unit 4 based on these signals. Therefore, the SERDES unit 4 can maintain a stable state even when there is no transmission data from the ONU, with a simple structure, which makes it possible to shorten the standby period until data can be received from the ONU. Furthermore, depending on a configuration of a phase synchronizing circuit, it is possible to further shorten the standby period by matching a phase of clock for transmitting dummy data and a phase of a reference clock.

### Second embodiment

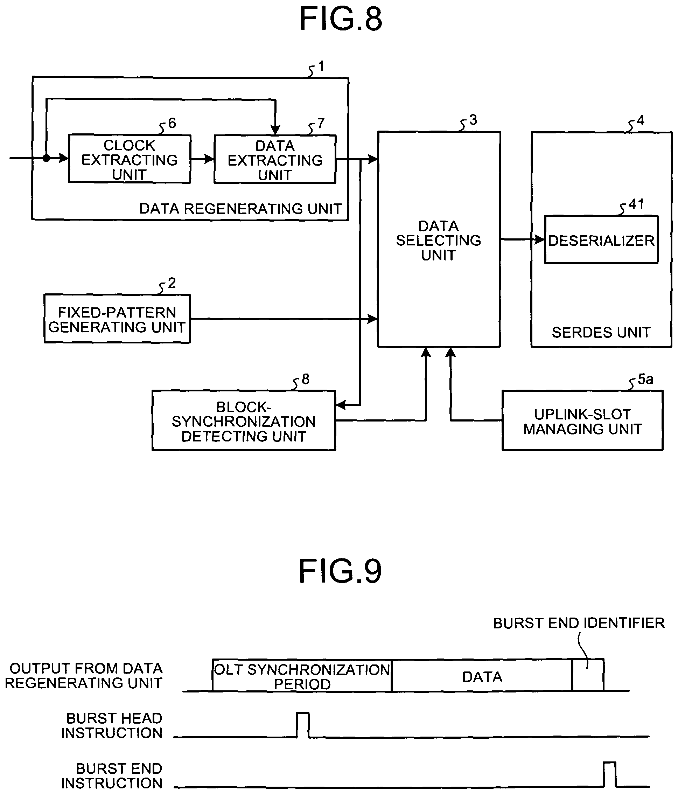

FIG. 8 is a functional configuration example of an optical line termination (OLT) according to a second embodiment of the present invention. As shown in FIG. 3, the optical line termination according to the present embodiment has the same configuration as the optical line termination according to the first embodiment except that the uplink-slot managing unit 5 of the first embodiment is replaced with an uplink-slot managing unit 5a and a block-synchronization detecting unit 8 is added. Constituent elements having functions same as those described in the first embodiment are denoted by like reference signs in the first embodiment and explanations thereof will be omitted.

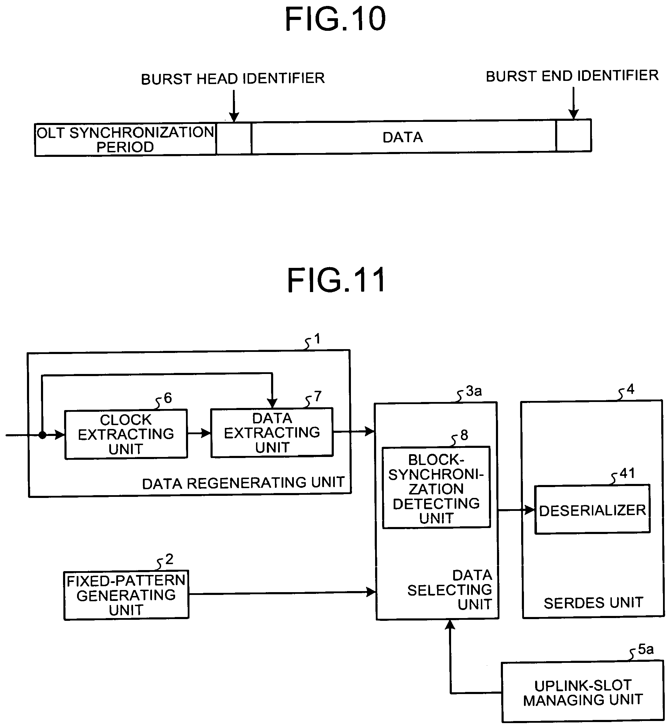

A difference between the present embodiment and the first embodiment is that the burst end instruction signal is output from the block-synchronization detecting unit 8. Operations of the present embodiment other than this are same as those of the first embodiment. FIG. 9 is an example of an operation according to the present embodiment, and FIG. 10 is an example of a format of data transmitted from the ONU to the OLT. As shown in FIG. 10, the data transmitted from the ONU to the OLT is formed of an OLT synchronization period indicating a standby period before transmitting burst data, a burst head identifier that is an identifier indicating a burst head, data that is data to be transmitted, and a burst end identifier (a termination code) that is an identifier indicating a burst end. The OLT synchronization period is a standby period until the OLT becomes able to receive data from the ONU, which is a period during which any actual data is not transmitted.

In the first embodiment, the uplink-slot managing unit 5 outputs the burst start instruction signal and the burst end instruction signal based on the control information of the transmission timing of the ONU; however, there is an error between the instruction of the transmission timing to the ONU and a timing at which the OLT actually receives the burst data transmitted by the ONU. This error is generally considered to be smaller than the OLT synchronization period, but is considerably larger than a period of the burst end identifier. In the example shown in FIG. 4, although a start position of the burst data, that is, a start position of the OLT synchronization period and the burst head instruction position differ from each other, it does not matter because the burst head instruction position is within the OLT synchronization period.

On the other hand, as for the end of the burst data, when the error is larger than a period of a termination code, an error between an actual end timing of the burst data and an instruction of the end by the burst end instruction signal becomes large, and there is a possibility that the data selecting unit 3 switches to the fixed pattern (selects the fixed pattern as the output to the SERDES unit 4) while data is output from the data extracting unit 7. Conversely, it can be considered that a time from the end of the burst data to the switch to the fixed pattern is increased.

To deal with the problem, in the present embodiment, the block-synchronization detecting unit 8 stores a data pattern of the burst end identifier, and compares the stored pattern with burst data output from the data regenerating unit 1 (a pattern check). When the burst data and the stored pattern match each other, the block-synchronization detecting unit 8 determines that a code indicating the end of the burst data (a burst end identifier) is detected, and outputs the burst end instruction signal indicating the burst end.

The data selecting unit 3 then selects data to be output to the SERDES unit 4 based on the burst end instruction signal in the same manner as the first embodiment. Therefore, in the present embodiment, it is possible to reduce the error in switching to the fixed pattern. The uplink-slot managing unit 5a according to the present embodiment does not need to output the burst end instruction signal, but operations thereof other than this are same as those of the uplink-slot managing unit 5 according to the first embodiment. In addition, operations of the present embodiment other than those explained above are same as those of the first embodiment.

As described above, in the present embodiment, it is configured that the block-synchronization detecting unit 8 outputs the burst end instruction signal indicating the burst end when the termination code is detected based on the burst data. Therefore, it is possible to obtain the same effect as the first embodiment, and at the same time, it is possible to prevent an inappropriate switch of the data selecting unit 3 due to the error in the arrival timing of data.

### Third embodiment

FIG. 11 is a functional configuration example of an optical line termination (OLT) according to a third embodiment of the present invention. As shown in FIG. 5, the optical line termination according to the present embodiment has the same configuration as the optical line termination according to the second embodiment except that the block-synchronization detecting unit 8 is included in a data selecting unit 3a and the data selecting unit 3 is replaced with the data selecting unit 3a. Constituent elements having functions same as those described in the first or second embodiment are denoted by like reference signs in the first or second embodiment and explanations thereof will be omitted.

In the present embodiment, the data selecting unit 3a performs a switching based on the burst end instruction signal output from the block-synchronization detecting unit 8 in the same manner as the second embodiment; however, the block-synchronization detecting unit 8 is set to an internal function of the data selecting unit 3a. With this configuration, the data selecting unit 3a detects the burst end by using data output from the data regenerating unit 1, so that it is possible to switch to the fixed pattern at a timing after an end of the actual burst data. That is, an error between the actual burst end and the burst end instruction is eliminated by performing a data selection while performing burst end detection, thus preventing an inappropriate switching to the fixed pattern.

An operation of the data selecting unit 3a including the block-synchronization detecting unit 8 therein is same as that of the data selecting unit 3 according to the second embodiment. In addition, operations of the present embodiment other than those explained above are same as those of the second embodiment.

In the above explanations, regarding the head of data, the data selecting unit 3a is configured to recognize the burst head position based on the burst head instruction signal output from the uplink-slot managing unit 5a in the same manner as the second embodiment. However, as shown in FIG. 10, the data transmitted from the ONU also includes the burst head identifier indicating the head of the burst data, which can be used to recognize the head of the burst. Similarly, the block-synchronization detecting unit 8 according to the second embodiment can output the burst head instruction signal by recognizing the head of the burst by using the burst head identifier instead of the burst head instruction signal from the uplink-slot managing unit 5a.

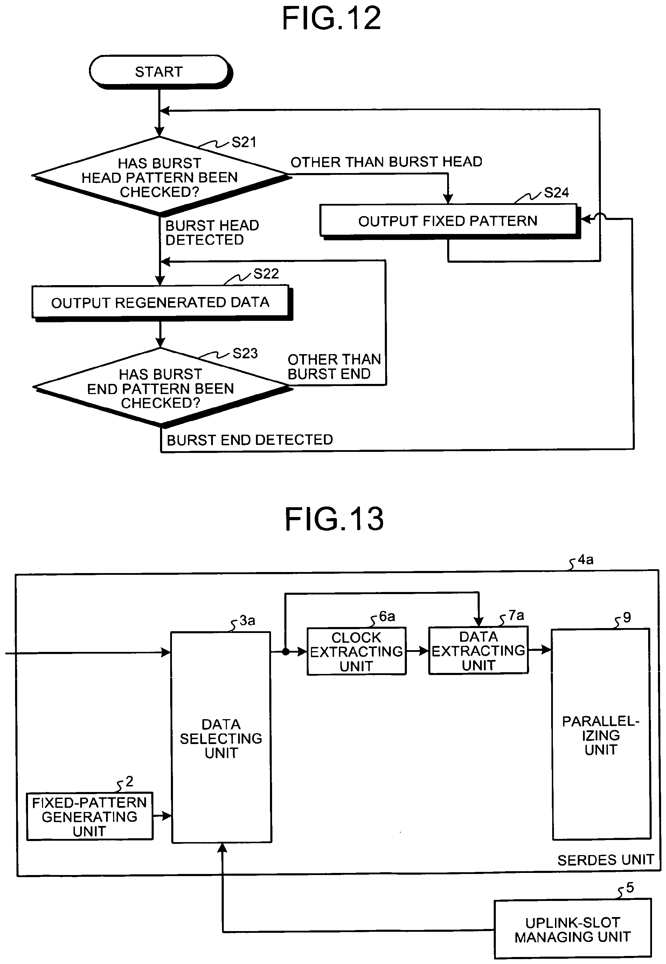

FIG. 12 is a flowchart of an example of an operation procedure of the data selecting unit 3a when performing recognition of the head of the burst. It is assumed that the data selecting unit 3a stores a data pattern of the burst head identifier and a data pattern of the burst end identifier. The data selecting unit 3a compares the stored data pattern of the burst head identifier with burst data output from the data regenerating unit 1 (burst head pattern check: Step S21). When the stored data pattern of the burst head identifier and the burst data output from the data regenerating unit 1 match each other (YES at Step S21), the data selecting unit 3a outputs the data output from the data regenerating unit 1 to the SERDES unit 4 (Step S22).

Thereafter, the data selecting unit 3 compares the stored data pattern of the burst end identifier with the burst data output from the data regenerating unit 1 (burst end pattern check: Step S23). When the stored data pattern of the burst end identifier and the burst data output from the data regenerating unit 1 match each other (YES at Step S23), the data selecting unit 3a selects data output from the fixed-pattern generating unit 2, outputs the selected data to the SERDES unit 4 (Step S24), and returns to Step S21. On the other hand, when it is determined that the data do not match each other at Step S21 (NO at Step S21), the process proceeds to Step S24. When it is determined that the data do not match each other at Step S23 (NO at Step S23), the process returns to Step S22.

As described above, in the present embodiment, it is configured that the block-synchronization detecting unit 8 same as that of the second embodiment is included in the data selecting unit 3a. Therefore, the data selection can be performed while performing the burst end detection, and as a result, it is possible to perform the operation of the second embodiment more rapidly and accurately.

### Fourth embodiment

FIG. 13 is a functional configuration example of an optical line termination according to a fourth embodiment of the present invention. As shown in FIG. 6, the optical line termination according to the present embodiment includes a SERDES unit 4a and the uplink-slot managing unit 5 that is same as that of the first embodiment. The SERDES unit 4a according to the present embodiment is configured by combining the data regenerating unit 1 and the SERDES unit 4 according to the first embodiment and including the fixed-pattern generating unit 2 therein. Constituent elements having functions same as those described in the first embodiment are denoted by like reference signs and explanations thereof will be omitted.

The SERDES unit 4a is configured by the fixed-pattern generating unit 2 that is same as that of the first embodiment, the data selecting unit 3a, a clock extracting unit 6a, a data extracting unit 7a, and a parallelizing unit 9. The data regenerating unit 1 according to the first embodiment includes the clock extracting unit 6 and the data extracting unit 7; however, the deserializer 41 of the SERDES unit 4 according to the first embodiment also performs the clock extraction and the data extraction, and the parallelization process is performed thereafter. In the present embodiment, as shown in FIG. 13, functions of the clock extraction and the data extraction are integrated to a single point.

In the data selecting unit 3a, the input burst data is not data after the clock extraction and the data extraction (output from the data regenerating unit 1) but data before the clock extraction and the data extraction, and the data selecting unit 3a outputs the selected data (selects either the fixed pattern or the burst data) to the clock extracting unit 6a; however, functions and operations other than those explained above are same as those of the first embodiment, and the data selecting unit 3a selects data to be output based on the burst end instruction signal and the burst head instruction signal output from the uplink-slot managing unit 5.

Furthermore, the clock extracting unit 6a and the data extracting unit 7a are same as the clock extracting unit 6 and the data extracting unit 7 according to the first embodiment except that a data input source is the data selecting unit 3a and an output destination is the parallelizing unit 9 and to which data of a fixed pattern selected by the data selecting unit 3a is input. The parallelizing unit 9 is a functional unit that performs a parallelizing process from among processes of the SERDES unit 4 according to the first embodiment. Operations of the present embodiment other than those explained above are same as those of the first embodiment.

As described above, in the present embodiment, it is configured that the data regenerating unit 1 and the SERDES unit 4 according to the first embodiment are integrated to a single element, and processing units that perform the clock extraction and the data extraction are set to be common. Therefore, the process can be performed more efficiently than that of the first embodiment, and as a result, it is possible to obtain the same effect as the first embodiment and to shorten the standby period required for data regeneration.

### Industrial Applicability

As described above, the optical line termination and the data reception processing method according to the present invention are useful for a PON system, and are particularly suitable in a case of using a PLL for clock extraction.

### Reference Signs List

- 1: DATA REGENERATING UNIT
- 2: FIXED-PATTERN GENERATING UNIT
- 3, 3a: DATA SELECTING UNIT
- 4, 4a: SERDES UNIT
- 5, 5a: UPLINK-SLOT MANAGING UNIT
- 6, 6a: CLOCK EXTRACTING UNIT
- 7, 7a: DATA EXTRACTING UNIT
- 8: BLOCK-SYNCHRONIZATION DETECTING UNIT
- 9: PARALLELIZING UNIT
- 10: DATA-REGENERATION SELECTING UNIT
- 11: MAC PROCESSING UNIT
- 12: REFERENCE CLOCK
- 13: FRAME BUFFER
- 41: DESERIALIZER
- 42: SERIALIZER
- 43: PLL UNIT
- 44: 1-TO-16 PARALLELIZING UNIT
- 45: BUFFER MEMORY
- 51: ALLOCATION-AMOUNT CALCULATING UNIT

## Claims

1. An optical line termination comprising a SERDES (4a) that parallelizes burst data received from a termination device, wherein
the SERDES (4a) includes
a dummy-data generating unit (2) that generates dummy data,
a data selecting unit (3a) that selects either the dummy data or the burst data based on whether there is the burst data,
a clock extracting unit (6a) that extracts clock from data selected by the data selecting unit (3a),
a data extracting unit (7a) that extracts information data based on clock extracted by the clock extracting unit (6a) and data selected by the data selecting unit (3a), and
a parallelizing unit (9) that parallelizes information data extracted by the data extracting unit (3a),
wherein the dummy-data generating unit (2) generates the dummy data such that the dummy data has data changes from which the clock extracting unit (6a) is capable of extracting clock, and
the data selecting unit detects whether there is the burst data based on a data-head instruction signal indicating a head of the burst data and a data-end instruction signal indicating an end of the burst data.

2. The optical line termination according to claim 1 wherein the dummy data is fixed data.

3. The optical line termination according to claim 2, wherein the dummy data has a comparable probability of occurrence of 0's and 1's in a predetermined period so that phase synchronization in the SERDES (4a) is capable to be maintained.

4. The optical line termination according to claim 1, further comprising an uplink-slot managing unit (5) that controls a transmission timing of the burst data transmitted from the termination device and generates the data-head instruction signal and the data-end instruction signal based on the transmission timing.

5. The optical line termination according to claim 1, further comprising:
an uplink-slot managing unit (5a) that controls a transmission timing of the burst data transmitted from the termination device and generates a data-head instruction signal based on the transmission timing; and
a block-synchronization detecting unit (8) that generates a data-end instruction signal based on a termination code, which indicates an end of the burst data and is included in burst data transmitted from the termination device,

6. The optical line termination according to claim 5, further comprising a data extracting unit (7) that extracts data from burst data transmitted from the termination device and supplies extracted data to the data selecting unit (3), wherein
the block-synchronization detecting unit (8) generates the data-end instruction signal based on the termination code of the burst data extracted by the data extracting unit.

7. The optical line termination according to claim 1, further comprising a block-synchronization detecting unit (8) that generates a data-head instruction signal based on a start code indicating a start of the burst data included in burst data transmitted from the termination device and generates a data-end instruction signal based on a termination code indicating an end of the burst data included in burst data transmitted from the termination device.

8. A PON system comprising:
a termination device; and
an optical line termination connected to the termination device, wherein
the optical line termination includes
a SERDES (4a) that parallelizes burst data received from the termination device,
a dummy-data generating unit (2) that generates dummy data that is data according to a predetermined operation rule,
a data selecting unit (3) that selects either the dummy data or the burst data based on a data-head instruction signal indicating a head of the burst data and a data-end instruction signal indicating an end of the burst data, and inputs selected data to the SERDES (4a) as data to be parallelized,
a clock extracting unit (6a) that extracts clock from data selected by the data selecting unit (3a),
a data extracting unit (7a) that extracts information data based on clock extracted by the clock extracting unit (6a) and data selected by the data selecting unit (3a), and
a parallelizing unit (9) that parallelizes information data extracted by the data extracting unit (3a),
wherein the dummy-data generating unit (2) generates the dummy data such that the dummy data has data changes from which the clock extracting unit (6a) is capable of extracting clock.

9. A data reception processing method for an optical line termination including a SERDES (4a) that parallelizes burst data received from a termination device, the method comprising:
a dummy-data generating step of generating dummy data;
a data selecting step of selecting either the dummy data or the burst data based on a data-head instruction signal indicating a head of the burst data and a data-end instruction signal indicating an end of the burst data, and inputting selected data to the SERDES (4a) of the optical line termination as data to be parallelized;
a clock extracting step of extracting clock from data selected in the data selecting step,
a data extracting step of extracting information data based on clock extracted in the clock extracting step and data selected in the data selecting step, and
a parallelizing step of parallelizing information data extracted in the data extracting step,
wherein, in the dummy-data generating step, the dummy data is generated such that the dummy data has data changes from which clock is capable of being extracted.

## Patentansprüche

1. Optischer Leitungsabschluss, der einen SerDes (4a) umfasst, der von einer Abschlussvorrichtung empfangene Burst-Daten parallelisiert, wobei
der SerDes (4a) umfasst:
eine Dummy-Daten-Erzeugungseinheit (2), die Dummy-Daten erzeugt,
eine Datenauswahleinheit (3a), die entweder die Dummy-Daten oder die Burst-Daten auf Grundlage dessen auswählt, ob die Burst-Daten vorhanden sind,
eine Taktextrahierungseinheit (6a), die den Takt aus Daten extrahiert, die durch die Datenauswahleinheit (3a) ausgewählt wurden,
eine Datenextrahierungseinheit (7a), die Informationsdaten auf Grundlage eines durch die Taktextrahierungseinheit (6a) extrahierten Takts und durch die Datenauswahleinheit (3a) ausgewählter Daten extrahiert, und
eine Parallelisierungseinheit (9), die Informationsdaten parallelisiert, die durch die Datenextrahierungseinheit (3a) extrahiert wurden,
wobei die Dummy-Daten-Erzeugungseinheit (2) die Dummy-Daten so erzeugt, dass die Dummy-Daten Datenänderungen aufweisen, aus denen die Taktextrahierungseinheit (6a) Takt extrahieren kann, und
die Datenauswahleinheit auf Grundlage eines Datenkopf-Anweisungssignals, das einen Kopf der Burst-Daten anzeigt, und eines Datenende-Anweisungssignal, das ein Ende der Burst-Daten anzeigt, erfasst, ob die Burst-Daten vorhanden sind.

2. Optischer Leitungsabschluss nach Anspruch 1, wobei die Dummy-Daten feste Daten sind.

3. Optischer Leitungsabschluss nach Anspruch 2, wobei die Dummy-Daten eine vergleichbare Eintrittswahrscheinlichkeit von 0en und 1en in einem vorgegebenen Zeitraum aufweisen, so dass Phasensynchronisation im SerDes (4a) aufrechterhalten werden kann.

4. Optischer Leitungsabschluss nach Anspruch 1, ferner eine Uplink-Slot-Verwaltungseinheit (5) umfassend, die eine Übertragungszeitsteuerung der von der Abschlussvorrichtung übertragenen Burst-Daten steuert und das Datenkopf-Anweisungssignal und das Datenende-Anweisungssignal auf Grundlage der Übertragungszeitsteuerung erzeugt.

5. Optischer Leitungsabschluss nach Anspruch 1, ferner umfassend:
eine Uplink-Slot-Verwaltungseinheit (5a), die eine Übertragungszeitsteuerung der von der Abschlussvorrichtung übertragenen Burst-Daten steuert und ein Datenkopf-Anweisungssignal auf Grundlage der Übertragungszeitsteuerung erzeugt; und
eine Blocksynchronisations-Erfassungseinheit (8), die ein Datenende-Anweisungssignal auf Grundlage eines Abschlusscodes erzeugt, das ein Ende der Burst-Daten anzeigt und in den von der Abschlussvorrichtung übertragenen Burst-Daten enthalten ist.

6. Optischer Leitungsabschluss nach Anspruch 5, ferner eine Datenextrahierungseinheit (7) umfassend, die Daten aus von der Abschlussvorrichtung übertragenen Burst-Daten extrahiert und extrahierte Daten an die Datenauswahleinheit (3) liefert, wobei
die Blocksynchronisations-Erfassungseinheit (8) das Datenende-Anweisungssignal auf Grundlage des Abschlusscodes der von der Datenextrahierungseinheit extrahierten Burst-Daten erzeugt.

7. Optischer Leitungsabschluss nach Anspruch 1, ferner eine Blocksynchronisations-Erfassungseinheit (8) umfassend, die ein Datenkopf-Anweisungssignal erzeugt auf Grundlage eines Startcodes, der einen Beginn der Burst-Daten anzeigt, die in den von der Abschlussvorrichtung übertragenen Burst-Daten enthalten sind, und ein Datenende-Anweisungssignal auf Grundlage eines Abschlusscodes erzeugt, der ein Ende der Burst-Daten anzeigt, die in den von der Abschlussvorrichtung übertragenen Burst-Daten enthalten sind.

8. Ein PON-System, umfassend:
eine Abschlussvorrichtung; und
einen mit der Abschlussvorrichtung verbundenen optischen Leitungsabschluss, wobei
der optische Leitungsabschluss umfasst:
einen SerDes (4a), der die Burst-Daten parallelisiert, die von der Abschlussvorrichtung empfangen werden,
eine Dummy-Daten-Erzeugungseinheit (2), die Dummy-Daten erzeugt, die Daten gemäß einer vorgegebenen Betriebsregel sind,
eine Datenauswahleinheit (3), die entweder die Dummy-Daten oder die Burst-Daten auf Grundlage eines Datenkopf-Anweisungssignals, das einen Kopf der Burst-Daten anzeigt, und eines Datenende-Anweisungssignals, das ein Ende der Burst-Daten anzeigt, auswählt und ausgewählte Daten als zu parallelisierende Daten in den SerDes (4a) eingibt,
eine Taktextrahierungseinheit (6a), die Takt aus Daten extrahiert, die durch die Datenauswahleinheit (3a) ausgewählt wurden,
eine Datenextrahierungseinheit (7a), die Informationsdaten auf Grundlage eines von der Taktextrahierungseinheit (6a) extrahierten Takts und von der Datenauswahleinheit (3a) ausgewählter Daten extrahiert, und
eine Parallelisierungseinheit (9), die Informationsdaten parallelisiert, die von der Datenextrahierungseinheit (3a) extrahiert wurden,
wobei die Dummy-Datenerzeugungseinheit (2) die Dummy-Daten so erzeugt, dass die Dummy-Daten Datenänderungen aufweisen, aus denen die Taktextrahierungseinheit (6a) den Takt zu extrahieren kann.

9. Datenempfangsverarbeitungsverfahren für einen optischen Leitungsabschluss einschließlich eines SerDes (4a) umfasst, der von einer Abschlussvorrichtung empfangene Burst-Daten parallelisiert, wobei das Verfahren umfasst:
einen Dummy-Daten-Erzeugungsschritt zum Erzeugen von Dummy-Daten;
einen Datenauswahlschritt zum Auswählen entweder der Dummy-Daten oder der Burst-Daten auf Grundlage eines Datenkopf-Anweisungssignals, das einen Kopf der Burst-Daten anzeigt, und eines Datenende-Anweisungssignals, das ein Ende der Burst-Daten anzeigt, und zum Eingeben ausgewählter Daten als zu parallelisierende Daten in den SerDes (4a) des optischen Leitungsabschlusses;
einen Taktextrahierungsschritt zum Extrahieren des Takts aus den im Datenauswahlschritt ausgewählten Daten,
einen Datenextrahierungsschritt zum Extrahieren von Informationsdaten auf Grundlage des im Taktextrahierungsschritt extrahierten Takts und der im Datenauswahlschritt ausgewählten Daten, und
einen Parallelisierungsschritt zum Parallelisieren von Informationsdaten, die im Datenextrahierungsschritt extrahiert wurden,
wobei im Dummy-Daten-Erzeugungsschritt die Dummy-Daten so erzeugt werden, dass die Dummy-Daten Datenänderungen aufweisen, aus denen der Takt extrahiert werden kann.

## Revendications

1. Terminaison de ligne optique comprenant un sérialiseur/désérialiseur, SERDES, (4a), qui parallélise des données de paquet reçues en provenance d'un dispositif de terminaison, dans laquelle
le SERDES (4a) inclut :
une unité de génération de données factices (2) qui génère des données factices ;
une unité de sélection de données (3a) qui sélectionne soit les données factices, soit les données de paquet en fonction de la présence ou non de données de paquet ;
une unité d'extraction d'horloge (6a) qui extrait une horloge de données sélectionnées par l'unité de sélection de données (3a) ;
une unité d'extraction de données (7a) qui extrait des données d'information sur la base de l'horloge extraite par l'unité d'extraction d'horloge (6a), et de données sélectionnées par l'unité de sélection de données (3a) ; et
une unité de parallélisation (9) qui parallélise des données d'information extraites par l'unité d'extraction de données (3a) ;
dans laquelle l'unité de génération de données factices (2) génère les données factices de sorte que les données factices présentent des modifications de données à partir desquelles l'unité d'extraction d'horloge (6a) est en mesure d'extraire une horloge ; et
l'unité de sélection de données détecte si les données de paquet sont présentes sur la base d'un signal d'instruction de tête de données indiquant une tête des données de paquet et d'un signal d'instruction de fin de données indiquant une fin des données de paquet.

2. Terminaison de ligne optique selon la revendication 1, dans laquelle les données factices sont des données fixes.

3. Terminaison de ligne optique selon la revendication 2, dans laquelle les données factices présentent une probabilité comparable d'occurrence de « 0 » et « 1 » au cours d'une période prédéterminée, de sorte qu'une synchronisation de phase dans le SERDES (4a) peut être maintenue.

4. Terminaison de ligne optique selon la revendication 1, comprenant en outre une unité de gestion de fentes de liaison montante (5) qui commande une temporisation de transmission des données de paquet transmises à partir du dispositif de terminaison et qui génère le signal d'instruction de tête de données et le signal d'instruction de fin de données sur la base de la temporisation de transmission.

5. Terminaison de ligne optique selon la revendication 1, comprenant en outre :
une unité de gestion de fentes de liaison montante (5a) qui commande une temporisation de transmission des données de paquet transmises à partir du dispositif de terminaison et qui génère un signal d'instruction de tête de données sur la base de la temporisation de transmission ; et
une unité de détection de synchronisation de bloc (8) qui génère un signal d'instruction de fin de données sur la base d'un code de terminaison, lequel indique une fin des données de paquet et est inclus dans les données de paquet transmises à partir du dispositif de terminaison.

6. Terminaison de ligne optique selon la revendication 5, comprenant en outre une unité d'extraction de données (7) qui extrait des données de données de paquet transmises à partir du dispositif de terminaison et qui fournit des données extraites à l'unité de sélection de données (3), dans laquelle
l'unité de détection de synchronisation de bloc (8) génère le signal d'instruction de fin de données sur la base du code de terminaison des données de paquet extraites par l'unité d'extraction de données.

7. Terminaison de ligne optique selon la revendication 1, comprenant en outre une unité de détection de synchronisation de bloc (8) qui génère un signal d'instruction de tête de données sur la base d'un code de début indiquant un début des données de paquet, inclus dans des données de paquet transmises à partir du dispositif de terminaison, et qui génère un signal d'instruction de fin de données sur la base d'un code de terminaison indiquant une fin des données de paquet, inclus dans des données de paquet transmises à partir du dispositif de terminaison.

8. Système de réseau optique passif, PON, comprenant :
un dispositif de terminaison ; et
une terminaison de ligne optique connectée au dispositif de terminaison, dans lequel la terminaison de ligne optique inclut :
un sérialiseur/désérialiseur, SERDES, (4a), qui parallélise des données de paquet reçues en provenance du dispositif de terminaison ;
une unité de génération de données factices (2) qui génère des données factices qui correspondent à des données conformes à une règle de fonctionnement prédéterminée ;
une unité de sélection de données (3) qui sélectionne soit les données factices, soit les données de paquet, sur la base d'un signal d'instruction de tête de données indiquant une tête des données de paquet, et d'un signal d'instruction de fin de données indiquant une fin des données de paquet, et qui applique en entrée des données sélectionnées dans le SERDES (4a), en tant que des données à paralléliser ;
une unité d'extraction d'horloge (6a) qui extrait une horloge de données sélectionnées par l'unité de sélection de données (3a) ;
une unité d'extraction de données (7a) qui extrait des données d'information sur la base de l'horloge extraite par l'unité d'extraction d'horloge (6a), et de données sélectionnées par l'unité de sélection de données (3a) ; et
une unité de parallélisation (9) qui parallélise des données d'information extraites par l'unité d'extraction de données (3a) ;
dans lequel l'unité de génération de données factices (2) génère les données factices de sorte que les données factices présentent des modifications de données à partir desquelles l'unité d'extraction d'horloge (6a) est en mesure d'extraire une horloge.

9. Procédé de traitement de réception de données pour une terminaison de ligne optique comprenant un SERDES (4a) qui parallélise des données de paquet reçues en provenance d'un dispositif de terminaison, le procédé comprenant :
une étape de génération de données factices consistant à générer des données factices ;
une étape de sélection de données consistant à sélectionner soit les données factices, soit les données de paquet, sur la base d'un signal d'instruction de tête de données indiquant une tête des données de paquet, et d'un signal d'instruction de fin de données indiquant une fin des données de paquet, et à appliquer en entrée des données sélectionnées dans le SERDES (4a) de la terminaison de ligne optique, en tant que des données à paralléliser ;
une étape d'extraction d'horloge consistant à extraire une horloge de données sélectionnées à l'étape de sélection de données ;
une étape d'extraction de données consistant à extraire des données d'information sur la base de l'horloge extraite à l'étape d'extraction d'horloge et des données sélectionnées à l'étape de sélection de données ; et
une étape de parallélisation consistant à paralléliser des données d'information extraites à l'étape d'extraction de données ;
dans lequel, à l'étape de génération de données factices, les données factices sont générées de sorte que les données factices présentent des modifications de données à partir desquelles une horloge peut être extraite.
